# EUROPÄISCHE PATENTSCHRIFT

(11) **EP 1 179 737 B1**
(45) Veröffentlichungstag und Bekanntmachung des Hinweises auf die Patenterteilung: **09.03.2005**
(21) Anmeldenummer: 01000351.5
(22) Anmeldetag: 07.08.2001
(51) Int. Cl.: G01R 31/3183, G01R 31/3185

(54) **Anordnung zum Testen eines integrierten Schaltkreises**
Test arrangement for an integrated circuit
Agencement de test d'un circuit intégré

(30) Priorität: 10.08.2000 DE 10039001
(43) Veröffentlichungstag der Anmeldung: 13.02.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Hapke, Friedrich, Habsburgerallee 11 52064 Aachen (DE); Solbach, Rüdiger, Habsburgerallee 11 52064 Aachen (DE); Glowatz, Andreas, Habsburgerallee 11 52064 Aachen (DE)
(74) Vertreter: Volmer, Georg, Dipl.-Ing.

(56) Entgegenhaltungen:
- WO-A-98/26301
- US-A- 5 349 587
- US-A- 5 488 613

## Beschreibung

Die Erfindung betrifft eine Anordnung zum Testen eines integrierten Schaltkreises, welcher wenigstens zwei Schaltungsteile aufweist, die im Normalbetrieb mit wenigstens zwei verschiedenen Taktsignalen arbeiten.

Bei derartigen integrierten Schaltkreisen besteht grundsätzlich das Problem, dass es zwischen den verschiedenen Taktsignalen zeitliche Schwankungen geben kann, die die Arbeitsweise der Schaltung beeinflussen. Solche Phasenschwankungen oder Phasenverschiebungen können dann beispielsweise dazu führen, dass ein bestimmtes Flip-Flop in der Schaltung mit einem ersten Takt getaktet ist, ein Signal, das von einem zweiten Flip-Flop kommt, dass mit einem zweiten Takt getaktet ist, gerade noch übernimmt oder nicht. Diese Phasenschwankungen bzw. -verschiebungen, die derartige Probleme verursachen können, werden in der englischen Literatur als Skew bezeichnet. Um ein derartiger Fehlverhalten zu erkennen, wird jeder integrierte Schaltkreis nach der Fertigung getestet, wobei insbesondere die Skew-Problematik zu berücksichtigen ist. Da beim Testen auf einzelne Elemente der ggf. sehr komplexen integrierten Schaltung nicht zugegriffen werden kann, kann die Skew-Problematik zu falschen bzw. nicht auswertbaren Testergebnissen führen. Insbesondere kann nicht festgestellt werden, ob einzelne Elemente, die bezüglich des Skew-Verhaltens kritisch sind, einwandfrei arbeiten.

Aus dem US-Patent 5, 349, 587 ist eine Testanordnung bekannt, welche versucht, diese Problematik dadurch zu umgehen, dass beim Testen von integrierten Schaltungen, die mit mehreren Taktsignalen arbeiten, beim Testen nur jeweils ein Taktsignal aktiviert wird. Es werden auf diese Weise nacheinander alle Testsignale aktiviert, so dass zwar alle Schaltungselemente getestet werden können, der Testaufwand jedoch enorm ansteigt, da entsprechend viele Testvektoren vorzusehen sind. Daher ist diese Lösung für das Testen von in Serie hergestellten integrierten Schaltungskreisen wegen des zu hohen Aufwandes bzw. zu hohen zeitlichen Bedarfs nicht geeignet.

Es ist Aufgabe der Erfindung, eine Anordnung zum Testen von integrierten Schaltkreisen der eingangs genannten Art anzugeben, welche es gestattet, auch Schaltkreise, die mit mehreren Taktsignalen arbeiten, in möglichst kurzer Zeit und mit möglichst wenig Testvektoren zu testen.

Diese Aufgabe ist erfindungsgemäß dadurch gelöst, dass der zu testende integrierte Schaltkreis so ausgelegt ist,
dass jedes der Taktsignale von einer in der Anordnung vorgesehenen Testsoftware in einem Testbetrieb einzeln ein- und ausschaltbar ist
dass in der Anordnung ein Softwaremodell des zu testenden Schaltkreises vorgesehen ist, in welchem für solche Schaltungsteile, deren Arbeitsweise von mehreren Taktsignalen und deren Flankenunsicherheiten beeinflusst wird, ein X-Generator vorgesehen ist, der dann aktiviert wird und ein X-Signal liefert, wenn beim Testen mehr als eines die Arbeitsweise des Schaltungsteils beeinflussendes Taktsignale aktiviert ist,
dass die Testsoftware beim Testen zunächst alle Taktsignale aktiviert und Testergebnisse für diejenigen Schaltungsteile auswertet, für die in dem Softwaremodell kein X-Signal erscheint,
und dass die Testsoftware für diejenigen Schaltungsteile, für die in dem Softwaremodell beim Testen mit allen Taktsignalen ein X-Signal erschien, mehrere Testdurchläufe vornimmt, bei denen nur jeweils einer oder mehrere der die Arbeitsweise des Schaltungsteils beeinflussenden Taktsignale aktiviert ist/sind und nur diejenigen Tests der Schaltungsteile des Schaltkreises auswertet, für die in dem Softwaremodell kein X-Signal erscheint.

Für die erfindungsgemäße Test-Anordnung gilt folgende grundsätzliche Arbeitsweise: Es existiert einerseits ein realer integrierter Schaltkreis, der mittels in der Anordnung dafür vorgesehener Hardware zu testen ist, in dem also an dem Schaltkreis außen auftretende Signale abgegriffen werden und überprüft wird, ob diese mit dem Soll-Verhalten des Schaltkreises übereinstimmen. Parallel dazu existiert ein Softwaremodell der zu testenden Schaltung, aus dem einerseits das Soll-Verhalten bekannt ist und das andererseits in weiter unten zu beschreibender Weise dazu dient, festzustellen, welche Schaltungsteile der Schaltung ggf. mit mehreren gleichzeitig aktivierten Taktsignalen getestet werden können.
Die erfindungsgemäße Anordnung zum Testen eines integrierten Schaltkreises setzt voraus, dass dieser so ausgelegt ist, dass jedes der Taktsignale, das in dem integrierten Schaltkreis verwendet wird bzw. auftaucht, durch eine extern in der Anordnung vorgesehene Testsoftware im Testbetrieb einzeln ein- und ausschaltbar ist. Es soll also möglich sein, mittels der Testsoftware je nach Bedarf die einzelnen Taktsignale ein- oder auszuschalten, wobei es auch möglich sein soll, ggf. mehrere Taktsignale gleichzeitig zu aktivieren.

In an sich bekannter Weise ist in der erfindungsgemäßen Anordnung zum Testen des integrierten Schaltkreises ein Softwaremodell der Schaltung vorhanden, die in dem integrierten Schaltkreis vorgesehen ist und die zu testen ist. In der erfindungsgemäßen Anordnung ist das Softwaremodell jedoch so gestaltet, dass es für solche Schaltungsteile, deren Arbeitsweise von mehreren Taktsignalen und deren Flankenunsicherheit beeinflusst wird, ein X-Generator vorgesehen ist. Es handelt sich hierbei also um solche Schaltungsteile, für die die oben beschriebene Skew-Problematik zutrifft. Dieser X-Generator ist in dem Softwaremodell so ausgestaltet, dass er immer dann ein sogenanntes X-Signal liefert, wenn beim Testen mehr als eines die Arbeitsweise des betreffenden Schaltungsteils beeinflussenden Taktsignale aktiviert ist. Mit anderen Worten liefert der X-Generator immer dann das X-Signal, wenn die oben beschriebene Skew-Problematik für die betreffenden Schaltungsteile relevant sein könnte. Dies ist immer dann der Fall, wenn das Verhalten der Schaltungsteile von den genauen Phasenbeziehungen der involvierten Taktsignale abhängig ist.

Grundsätzlich ist es so, dass ein in dem Softwaremodell auftauchendes X-Signal immer in den Bereichen, in denen es auftaucht, für die dort befindlichen Schaltungselemente signalisiert, dass dort eine Skew-Problematik vorhanden ist.

Beim Vorgang des Testens wird die Testsoftware zunächst alle Taktsignale aktivieren, da auf diese Weise am schnellsten alle Elemente des integrierten Schaltkreises zu testen sind. Für diejenigen Schaltungsteile, für die die Skew-Problematik zu befürchten ist, wird jedoch in dem Softwaremodell der jeweils zugeordneten X-Generator aktiviert. Dies hat zur Folge, dass beim ersten Testdurchgang mit allen aktivierten Taktsignalen für einige Schaltungsteile ein X-Signal in dem Softwaremodell auftaucht. Dies signalisiert der Testsoftware, dass der Testdurchgang mit allen aktivierten Testsignalen für diese Schaltungsteile keine gültigen Ergebnisse liefert. Es werden somit in dem ersten Testdurchgang, in dem alle Taktsignale aktiviert sind, die Testergebnisse des realen integrierten Schaltkreises nur für solche Schaltungsteil ausgewertet, für die sich in dem Softwaremodell kein X-Signal ergibt.

Für diejenigen Schaltungsteile, für die sich in dem Softwaremodell ein X-Signal ergeben hat, werden danach weitere Testdurchläufe vorgenommen, in denen die Testsortware durch Deaktivieren weiterer Taktsignale wrsucht, für alle Schaltungsteile wirksame Testergebnisse zu erzielen, die wie gesagt nur dann vorliegen, wenn für die jeweiligen Schaltungsteile keine X-Signal erscheint. Dabei kann beispielsweise so vorgegangen werden, dass ausgehend von der Aktivierung aller Taktsignale im ersten Testdurchlauf nach und nach Taktsignale abgeschaltet werden, bis für das jeweilige Schaltungsteil kein X-Signal mehr erscheint. Dies kann im Extremfall dazu führen, dass nur noch ein Taktsignal aktiviert sein darf, bis kein X-Signal mehr erscheint.

Insgesamt wird durch die erfindungsgemäße Vorgehensweise erreicht, dass für eine relativ hohe Anzahl der Schaltungsteile in einem integrierten Schaltkreis bereits in dem ersten Testdurchgang, in dem alle Taktsignale aktiviert sind, gültige Testergebnisse erzielt werden. Nur für relativ wenige Schaltkreise, in denen in diesern Testdurchlauf ungültige Ergebnisse erzielt werden, sind weitere Testdurchläufe mit nach und nach deaktivierten Taktsignalen erforderlich. Somit wird die Anzahl der Testdurchläufe gegenüber dem Stand der Technik deutlich vermindert.

Eine Ausgestaltung der erfindungsgemaßen Test-Anordnung ist durch die Merkmale gemäß Patentanspruch 2. gekennzeichnet. Diese Hardwareanordnung ergibt in dem integrierten Schaltkreis eine relativ geringe Anzahl zusätzlicher Schaltungsteile, die für das Testen vorzusehen sind. Die vogesehenen Schaltungsteile sind in integrierten Schaltkreisen mit geringem Aufwand realisierbar.

Die oben bereits beschriebene Art der Vorgehensweise der Testdurchläufe kann vorteilhaft zur Erzielung einer möglichst geringen Anzahl von Testdurchläufen gemäß Patentanspruch 3. vorgenommen werden.

Nachfolgend wird ein Ausführungsbeipiel der Erfindung anhand der Zeichnung näher erläutert. Es zeigen:
Figur 1 eine schematische Darstellung von Schaltungsteilen eines zu testenden integrierten Schaltkreises mit zusätzlicher Hardware, die das Schalten einzelner Taktsignale in dem Schaltkreis gestattet und
Figur 2 eine schematische Darstellung der Testsofware, in der die Schaltungsteile gemäß Figur 1, X-Generatoren sowie eine Schaltlogik zum Schalten der X-Generatoren vorgesehen sind.

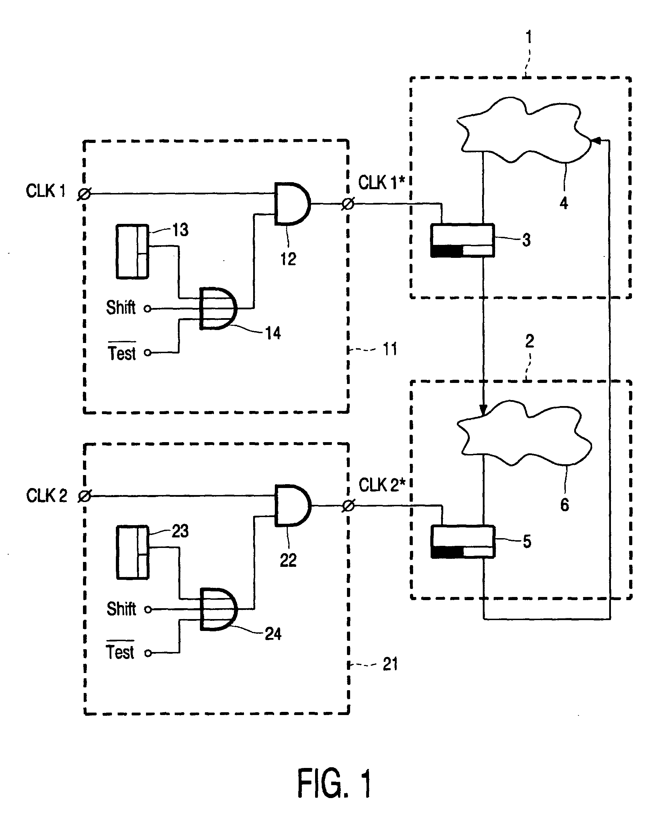

Die schematische Darstellung gemäß Figur 1 zeigt in ihrem rechten Teil einige Ausschnitte eines im übrigen nicht näher dargestellten integrierten Schaltkreises, So sind ein erstes Schaltungselement 1 und ein zweites Schaltungselement 2 vorgesehen. In dem ersten Schaltungselement 1 sind im übrigen nicht weiter dargestellte und nur schematisch angedeutete Schaltungsteile 4 vorgesehen. Es ist ferner ein Schaltungsteil 3 dargestellt, welches mittels eines ersten Taktsignals (CLK 1*) getaktet wird.

Zu dem Schaltungselement 2 gehören dort ebenfalls nicht näher dargestellte und nur schematisch angedeutete Schaltungsteile 6. In diesem Ausschnitt ist jedoch auch ein Schaltungsteil 5 vorgesehen, welches detailliert dargestellt ist und mittels eines zweiten Taktsignals CLK 2* getaktet wird.

Bei den Schaltungsteilen 3 und 5 handelt es sich um solche Schaltungsteile, des zu testenden integrierten Schaltkreises, deren Arbeitsweise von mehreren Taktsignalen und deren Flankenunsicherheit beeinflusst wird. In diesem Beispielsfall wird davon ausgegangen, dass das genaue Phasenverhalten der beiden Taktsignale CLK 1* und CLK 2* zueinander das Verhalten der Schaltungsteile 3 und 5 beeinflusst. Es kann beispielsweise so sein, dass die Übernahme der Daten aus dem Schaltungsteil 3 in den Schaltungsteil 5 von dem genauen Phasenverhalten der beiden Taktsignale CLK 1 * und CLK 2* zueinander abhängt.

Dies hat beim Testen zur Folge, dass bei gleichzeitiger Aktivierung der beiden Taktsignale CLK 1 * und CLK 2* je nach Skew-Verhalten verschiedene Ergebnisse erzielt werden können, da ggf. Daten mit einer bestimmten Flanke des Taktes CLK 2* in das Schaltungsteil 5 übernommen werden können oder nicht. Es ist daher nicht möglich, das Verhalten der Schaltung sicher zu testen, wenn beide Taktsignale aktiviert sind. Wie noch weiter unten detailliert zu beschreiben sein wird, ist hierfür in der erfindungsgemäßen Anordnung eine spezielle Vorgehensweise der Testsoftware und ein spezielles Softwaremodell der Schaltung vorgesehen.

Die entsprechende Arbeitsweise der Testsoftware setzt jedoch in der Hardwareschaltung, die in Figur 1 angedeutet ist, voraus, dass in dem integrierten Schaltkreis die einzelnen Taktsignale schaltbar sind. Dafür ist eine erste Schaltlogik 11 vorgesehen, welche es gestattet, ein ursprüngliches erstes Taktsignal CLK 1 nach Bedarf zu schalten und daraus das erste Taktsignal CLK 1 * zu formen.

In der ersten Schaltlogik 11 ist ein Und-Gatter vorgesehen, dem einerseits das ursprüngliche Taktsignal CLK 1 zugeführt wird und dem außerdem an einem zweiten Eingang ein Ausgangssignal eines Oder-Gatters 14 zugeführt wird. Das Oder-Gatter 14 hat drei Eingänge, an die ein Ausgangssignal eines ersten Flip-Flops 13, ein Schiebesignal, das in der Figur mit Shift gekennzeichnet ist, sowie ein invertiertes Testsignal, das in der Figur mit Test dargestellt ist, geführt werden.

Bei dem Schiebesignal Shift handelt es sich um ein Signal, welches beim Testen aktiviert wird, solange neue Daten in den integrierten Schaltkreis geschoben werden oder aus diesem ausgelesen werden. Das invertierte Testsignal Test hat dann niedrige Amplitude, wenn ein Testvorgang stattfindet.

Während eines Testvorgangs hat das Signal Test niedrige Amplitude 1. Ferner hat das Schiebesignal Shift niedrige Amplitude 1, wenn kein Schiebevorgang von Daten in den integrierten Schaltkreis oder aus diesem stattfindet. Somit hängt während dieser Betriebszeiten beim Testen das Ausgangssignal des Oder-Gatters davon ab, welchen Zustand das Flip-Flop 13 hat. Der Zustand des Flip-Flops 13 wiederum hängt davon ab, ob von der Testsoftware in in der Figur nicht näher dargestellter Weise zuvor eine 0 oder eine 1 in das Flip-Flop geschoben wurde. Diese 0 oder 1 bestimmt über das Oder-Gatter 14, dessen Ausgangssignal auf den zweiten Eingang des Und-Gatters 12 gelangt, ob das ursprüngliche Taktsignal CLK 1 an den Ausgang des Und-Gatters gelangt oder nicht. Im Ergebnis kann auf diese Weise in Abhängigkeit davon, ob durch die Testsoftware eine 0 oder eine 1 in das Flip-Flop 13 geladen wurde, das Taktsignal CLK 1* ein- oder ausgeschaltet werden.

In entsprechender Weise sind in der zweiten Schaltlogik 21 ein Und-Gatter 22, ein Oder-Gatter 24 sowie ein zweites Flip-Flop 23 vorgesehen. Diese arbeiten in entsprechender Weise wie in der ersten Schaltlogik 11 und gestatten es auf diese Weise, das zweite Taktsignal CLK 2* durch die Testsoftware gesteuert ein- oder auszuschalten.

In einem integrierten Schaltkreis können selbstverständlich mehr als zwei Taktsignale vorgesehen sein. Es ist in einem solchen Falle für jedes Taktsignal eine Schaltlogik vorgesehen, die entsprechend den Schaltlogiken 11 bzw. 21 der Darstellung gemäß Figur 1 ausgestaltet sein kann. Es ist natürlich auch eine andere Ausgestaltung der Schaltlogiken möglich; es muss jedoch gewährleistet sein, dass jedes Taktsignal des integrierten Schaltkreises durch Daten der Testsoftware einzeln ein- und ausschaltbar ist.

Beim Testen eines integrierten Schaltkreises, von dem in der Figur 1 nur Teile dargestellt sind, wird so vorgegangen, dass parallel zu den Messungen bzw. zum Testen der tatsächlichen Hardware des integrierten Schaltkreises ein Softwaremodell vorgesehen ist, welches das Verhalten des Schaltkreises simuliert und welches es somit gestattet, ein Soll-Verhalten der Schaltung vorzugeben.

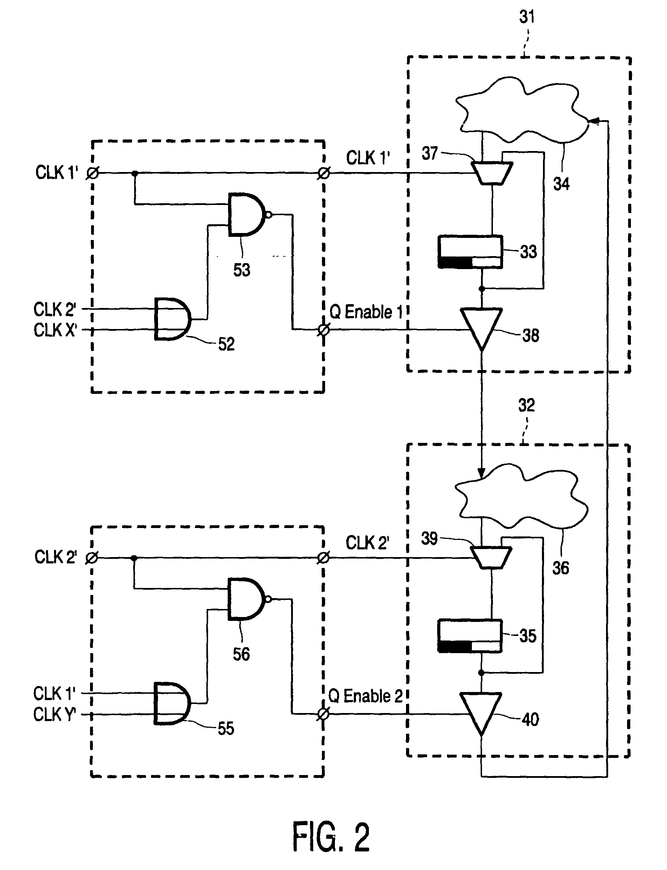

In dem rechten Teil der Figur 2 sind Teile eines solchen Softwaremodells angedeutet. Es würde sich dabei gerade um diejenigen Teile handeln, die diejenigen in Figur 1 dargestellten Schaltungsteile des integrierten Schaltkreises simulieren sollen. Es soll also ein Schaltungsausschnitt 31 des Softwaremodells gemäß Figur 2 einen Schaltungsausschnitt 1 der Hardware gemäß Figur 1 simulieren. Entsprechendes gilt für einen zweiten Ausschnitt 32 gemäß Figur 2, die in den entsprechenden Ausschnitt der Hardware gemäß Figur 2 in der Software simulieren sollen.

Der Ausschnitt 31 zeigt Schaltungsteile 34, die nicht näher dargestellt sind. Er beinhaltet aber auch einen Schaltungsteil 33, der den Schaltungsteil 3 der tatsächlichen Hardware gemäß Figur 1 als Modell repräsentiert. In dem Ausschnitt 32 des Softwaremodells ist ferner ein Schaltungsteil 35 vorgesehen, der den realen Schaltungsteil 5 der Schaltung gemäß Figur 1 als Modell repräsentiert.

Wie oben bereits erläutert wurde, soll im folgenden davon ausgegangen werden, dass die beiden Schaltungsteile 3 und 5 der Darstellung gemäß Figur 1 in dem integrierten Schaltkreis bezüglich ihres Skew-Verhaltens kritisch sind Daher wird bei der Gestaltung des Softwaremodells berücksichtigt, dass diese beiden Schaltungsteile 3 und 5 und somit die entsprechenden Schaltungsteile 33 bzw. 35 in dem Softwaremodell nicht unter gleichzeitiger Aktivierung der Taktsignale CLK 1* und CLK 2* getestet werden können bzw. sollten. Es sind daher sogenannte X-Generatoren 38 und 40 vorgesehen, die in dem Softwaremodell jeweils den Schaltungsteilen 33 und 35 nachgeschaltet sind und welche dann ein X-Signal als Ausgangssignal liefern, wenn sie aktiviert sind Auf die Aktivierung der X-Generatoren 38 und 40 wird weiter unten noch im Detail einzugehen sein.

In dem Softwaremodell entsprechend der schematischen Darstellung gemäß Figur 2 wird das etste Schaltungsteil 33 mittels eines Taktsignals CLK 1' getaktet, welches in der realen Hardware dem Taktsignal CLK 1* entspricht.

Das Taktsignal CLK 1' gelangt an einen Schalteingang eines Multiplexers 37, dessen beiden andere Eingängen einerseits das Signal aus den Schaltungsteilen 34 und andererseits ein rückgekoppeltes Ausgangssignal des Schaltungsteils 33 zugeführt wird. Der Multiplexer 37 dient dazu, in einem Testvorgang ggf. den Zustand des Schaltungsteils 33, bei dem es sich beispielsweise um einen Flip-Flop handeln kann, zu halten, damit nachfolgend mit diesem gehaltenen Zustand des Schaltungsteils 33 in anderen Schaltungsteilen in ggf. mehreren Durchläufen Tests durchgeführt werden können.

In entsprechender Weise ist dem Schaltungsteil 35 ein Multiplexer 39 zugeordnet, dessen Schalteingang ein Taktsignal CLK 2' zugeführt wird, welches dem Taktsignal CLK 2* in der realen Schaltung gemäß Figur 1 entspricht.

Für den Testvorgang entscheidend ist, wie unten noch weiter zu erläutern sein wird, wann die x-Generatoren 38 bzw. 40 über die Enable-Signale Enable 1 bzw. Enable 2 aktiviert werden und wann nicht.

Es wird davon ausgegangen, dass sowohl für das Schaltungsteil 3 der Schaltung gemäß Figur 1 wie auch für das Schaltungsteil 5 gilt, dass kein anderer Clock außer dem zugeordneten Clock CLK1* bzw. CLK 2* aktiviert sein darf um eine einwandfreie Messung des Verhaltens des jeweiligen Schaltungsteils 3 bzw. 5 ohne die oben beschriebene Skew-Problematik möglich ist. Mit anderen Worten: Es darf kein anderer Clock eingeschaltet sein.

Entsprechend ist das Softwaremodell gemäß Figur 2 ausgestaltet. Es ist eine invertierende Und-Verknüpfung 53 vorgesehen, Welche das Taktsignal CLK 1' und über eine Oder-Verknüpfung die beiden Taktsignale CLK 2' und CLK x' miteinander verknüpft. Das Schaltungsteil 39 kann nur dann gemessen werden, wenn der Clock CLK 1' bzw. in der realen Schaltung das Taktsignal CLK 1* aktiviert ist. Die Softwarelogik gemäß Figur 2 ist jedoch so geschaltet, dass der X-Generator 38 bereits dann aktiviert wird, wenn eines der beiden anderen Taktsignale CLK 2' oder CLK x' vorhanden ist. Es wird dann nämlich bei vorhandenem Clock CLK 1' eine logische 0 am Ausgang der Und-Verknüpfung 53 erscheinen, welche den X-Generator 38 aktiviert.

Entsprechendes gilt für den Schaltungsteil 35, dessen zugeordneter X-Generator 40 dann aktiviert wird, wenn einer der anderen Clocks CLK 1' bzw. CLK y' aktiv ist.

Mit anderen Worten: Die Schaltungsteile 33 bzw. 35 können ohne Einfluss der Skew-Problematik nur dann gemessen werden, wenn ihnen der jeweils zugeordnete Takt CLK 1' bzw. CLK2' ausschließlich aktiviert ist.

Diese Auslegung des Softwaremodells wird vorgenommen in Abhängigkeit des Verhaltens der realen Schaltung. D. h. es muss für jedes Schaltungsteil der realen Schaltung überlegt werden, welche Skew-Problematiken ggf. auftreten können und welche Taktsignale beim Testen maximal aktiviert sein dürfen. In dem Ausführungsbeispiel dürfen die Taktsignale CLK 2' und CLK x' im Falle des Schaltunggsteils 33 und die Taktsignale CLK 1' bzw. CLK y' im Falle des Schaltungsteils 35 beim Testen nicht aktiviert sein. Wird dennoch ein Testen vorgenommen, wenn eines dieser Taktsignale aktiviert ist, erzeugt der jeweils zugeordnete X-Generator 38 oder 40 ein entsprechendes X-Signal.

Dieses X-Signal signalisiert einer in der Figur nicht dargestellten Testsoftware ein ungültiges Messergebnis bzw. ein solches, was von der Skew-Problematik beeinflusst ist.

Infolge dessen kann die Testsoftware beim Testen des realen Schaltkreises parallel das Softwaremodell beobachten und laufend feststellen, welche Testergebnisse gültig sind. Dies sind nämlich diejenigen Testergebnisse, für die in dem Softwaremodell kein X-Signal auftaucht.

Die Vorgehensweise beim Testen kann beispielsweise folgende sein:

Ein Schaltkreis wird zunächst unter Aktivierung aller Taktsignale geprüft. Es wird das Softwaremodell beobachtet und die Testsoftware wertet in diesem ersten Durchgang nur die Testergebnisse für diejenigen Bauteile aus, für die in dem Softwaremodell kein X-Signal auftaucht. In weiteren folgenden Testdurchgängen müssen diejenigen Bauteile nochmals gemessen werden, für die im ersten Durchlauf in dem Softwaremodell ein X-Signal auftauchte. Dabei können die Clocks nacheinander einzeln deaktiviert werden bis für jedes Bauteil kein X-Signal mehr auftaucht. Diese Vorgehensweise kann einzeln für die verschiedenen Bauteile erfolgen. Somit kann für jedes Bauteil nacheinander eines der die Arbeitsweise dieses Bauteils beeinflussenden Taktsignale vorgenommen werden, bis für das Bauteil kein X-Signal mehr auftritt.

Insgesamt wird eine deutliche Verringerung der Test-Durchläufe erzielt, da für sehr viele Bauteile bereits im ersten Durchgang in dem alle Taktsignale aktiviert sind, gültige Testergebnisse erzielt werden können. Auch für diejenigen Bauteile, die nachfolgend unter Deaktivierung einzelner Taktsignale nochmals gemessen werden, wird gegenüber dem Stand eine Verringerung der Testdurchläufe erzielt, da es in vielen Fällen nicht erforderlich ist, alle Taktsignale zu erzeugen; es kann im Einzelfall beispielsweise genügen, eines von drei Taktsignalen zu deaktivieren um gültige Messergebnisse erzielen zu können.

Insgesamt wird gegenüber dem Stand der Technik eine deutliche Verringerung der Testdurchläufe erzielt. Gleichzeitig ist die erforderliche Hardware auf dem zu messenden integrierten Schaltkreis sehr gering, da hier nur ein einfaches Ein- und Ausschalten der einzelnen Taktsignale gewährleistet werden muss.

## Patentansprüche

1. Anordnung zum Testen eines integrierten Schaltkreises, welcher wenigstens zwei Schaltungsteile (1,2) aufweist, die im Normalbetrieb mit wenigstens zwei verschiedenen Taktsignalen arbeiten,
**dadurch gekennzeichnet,**
**dass** der zu testende integrierte Schaltkreis so ausgelegt ist, dass jedes der Taktsignale von einer in der Anordnung vorgesehenen Testsoftware in einem Testbetrieb einzeln ein- und ausschaltbar ist,
**dass** in der Anordnung ein Softwaremodell des zu testenden Schaltkreises vorgesehen ist, in welchem für solche Schaltungsteile (33, 35), deren Arbeitsweise von mehreren Taktsignalen und deren Flankenunsicherheiten beeinflusst wird, ein X-Generator (38,40) vorgesehen ist, der dann aktiviert wird und ein X-Signal liefert, wenn beim Testen mehr als eines die Arbeitsweise des Schaltungsteils (33,35) beeinflussendes Taktsignale aktiviert ist,
**dass** die Testsoftware beim Testen zunächst alle Taktsignale aktiviert und Testergebnisse für diejenigen Schaltungsteile (3,5) auswertet, für die in dem Softwaremodell (33,35) kein X-Signal erscheint,
und **dass** die Testsoftware für diejenigen Schaltungsteile (3,5), für die in dem Softwaremodell (33,35) beim Testen mit allen Taktsignalen ein X-Signal erschien, mehrere Testdurchläufe vornimmt, bei denen nur jeweils einer oder mehrere der die Arbeitsweise des Schaltungsteils (3,5) beeinflusenden Taktsignale aktiviert ist/sind und nur diejenigen Tests der Schaltungsteile (3,5) des Schaltkreises auswertet, für die in dem Softwaremodell (33,35) kein X-Signal erscheint.

2. Anordnung nach Anspruch 1,
**dadurch gekennzeichnet,**
**dass** in dem zu testenden Schaltkreis für alle Schaltungsteile (3,5), die selbst mit einem zugeordneten Takt arbeiten und deren Arbeitsweise auch von anderen Taktsignalen beeinflusst wird, jeweils ein von der Testsoftware ladbares Flip-Flop (13,23) vorgesehen ist, dessen Ausgangssignal auf ein Oder-Gatter (14,24) geführt ist, dessen weiteren Eingängen ein Shift-Signal, das während eines Schiebevorgangs, in dem neue Daten in oder aus dem Schaltungselement (3,5) geschoben werden, High-Pegel hat, sowie ein invertiertes Testsignal, das während des Testens Low-Pegel hat, zugeführt werden, und dass das Ausgangssignal des Oder-Gatters (14,24) auf einen Eingang eines Und-Gatters (12,22) geführt ist, dessen anderem Eingang das zugeordnete Taktsignal des jeweiligen Schaltungsteils (3,5) zugeführt wird und dessen Ausgangssignal dem Schaltungsteil (3,5) als Takt zugeführt wird.

3. Anordnung nach Anspruch 1,
**dadurch gekennzeichnet,**
**dass** die Testsoftware für diejenigen Schaltungselemente (3,5), für die in dem Softwaremodell (33,35) beim Testen mit allen Taktsignalen ein X-Signal erschien, zunächst Testdurchläufe vornimmt, bei denen nur jeweils einer die Arbeitsweise des Schaltungsteils (3,5) beeinflussenden Taktsignale deaktiviert ist, und dass die Testsoftware, sollte in diesem Test auch ein X-Signal für bestimmte Schaltungsteile (33,35) erscheinen, die Anzahl der deaktivierten Taktsignale soweit gesteigert bis in dem Softwaremodell für die Schaltungsteile (33,35) kein X-Signal mehr erscheint und eine Auswertung der Testergebnisse der betreffenden Schaltungsteile (3,5) erfolgen kann.

## Claims

1. An arrangement for testing an integrated circuit comprising at least two circuit sections (1, 2) which in normal operation operate with at least two different clock signals,
**characterized in that**
the integrated circuit to be tested is formed in such a way that each clock signal can be individually switched on and off during a test by test software provided in the arrangement,
**in that** a software model of the circuit to be tested is provided in the arrangement, which software model comprises an X generator (38, 40) for those circuit components (33, 35) whose mode of operation is influenced by a plurality of clock signals and their skew behavior, which X generator is activated and supplies an X signal when more than one clock signal influencing the mode of operation of the circuit components (33, 35) during testing is activated,
**in that**, during testing, the test software initially activates all clock signals and evaluates test results for those circuit components (3, 5) for which no X signal appears in the software model (33, 35),
and **in that** for those circuit components (3, 5) for which an X signal appeared in the software model (33, 35) during testing with all clock signals, the test software performs a plurality of test runs in which each time only one or more of the clock signals influencing the mode of operation of the circuit component (3, 5) is/are activated and evaluates only those tests of the circuit components (3, 5) of the circuit for which no X signal appears in the software model (33, 35).

2. An arrangement as claimed in claim 1,
**characterized in that**
the circuit to be tested for all circuit components (3, 5), which themselves operate at an assigned clock and whose mode of operation is also influenced by other clock signals, comprises a flip-flop (13, 23) which can be loaded by the test software and whose output signal is applied to an OR gate (14, 24), whose further inputs receive a shift signal which, during a shift operation in which new data are shifted into or out of the circuit component (3, 5) has a high level, as well as an inverted test signal which has a low level during testing, and **in that** the output signal of the OR gate (14, 24) is applied to an input of an AND gate (12, 22), whose other input receives the assigned clock signal of the relevant circuit component (3, 5) and whose output signal is supplied as a clock to the circuit component (3, 5).

3. An arrangement as claimed in claim 1,
**characterized in that**
the test software initially performs test runs for those circuit components (3, 5) for which an X signal appeared in the software model (33, 35) during testing with all clock signals, in which test runs each time only one of the clock signals influencing the mode of operation of the circuit component (3, 5) is deactivated, and **in that**, if also an X signal should appear in this test for given circuit components (33, 35), the test software increases the number of deactivated clock signals until no X signal appears any longer in the software model for the circuit components (33, 35) so that the test results of the relevant circuit components (3, 5) can be evaluated.

## Revendications

1. Agencement de test d'un circuit intégré qui présente au moins deux parties de circuit (1,2) qui travaillent en fonctionnement normal avec au moins deux signaux de synchronisation différents,
**caractérisé en ce**
**que** le circuit intégré à tester est conçu de telle sorte que chacun des signaux de synchronisation puisse être activé et désactivé individuellement par un logiciel de test prévu dans l'agencement dans un mode de test,
**que**, dans l'agencement, il est prévu un modèle logiciel du circuit à tester dans lequel, pour les parties de circuit (33, 35) dont le fonctionnement est influencé par plusieurs signaux de synchronisation et leurs incertitudes de flancs, il est prévu un générateur X (38, 40) qui est activé et délivre un signal X lorsque, pendant un test, plus d'un des signaux de synchronisation influençant le fonctionnement de la partie de circuit (33, 35) est activé,
**que** le logiciel de test active d'abord lors du test tous les signaux de synchronisation et évalue les résultats de test pour les parties de circuit (3, 5) pour lesquelles il n'apparaît pas de signal X dans le modèle logiciel (33, 35),
et **que** le logiciel de test pour les parties de circuit (3, 5) pour lesquelles un signal X est apparu dans le modèle logiciel (33, 35) dans le test avec tous les signaux de synchronisation effectue plusieurs cycles de test pour lesquels seuls un ou plusieurs des signaux de synchronisation influençant le fonctionnement de la partie de circuit (3, 5) sont activés et évalue seulement les tests des parties de circuit (3, 5) du circuit pour lesquelles aucun signal X n'apparaît dans le modèle logiciel (33, 35).

2. Agencement selon la revendication 1,
**caractérisé en ce**
**que**, dans le circuit à tester pour toutes les parties de circuit (3, 5) qui travaillent elles-mêmes avec une synchronisation affectée et dont le fonctionnement est également influencé par d'autres signaux de synchronisation, il est respectivement prévu une bascule bistable (13, 23) à charger par le logiciel de test dont le signal de sortie est dirigé sur une grille Ou (14, 24) aux autres entrées de laquelle sont amenés un signal Décalage qui a un niveau Haut pendant une procédure de décalage dans laquelle de nouvelles données sont introduites ou extraites de l'élément de circuit (3, 5) ainsi qu'un signal de test inversé qui a un niveau Bas pendant le test et que le signal de sortie de la grille Ou ( 14, 24) est dirigé sur une entrée d'une grille Et (12, 22) à l'autre entrée de laquelle est amené le signal de synchronisation affecté de la partie de circuit respective (3, 5) et son signal de sortie est amené comme un signal de synchronisation à la partie de circuit (3, 5).

3. Agencement selon la revendication 1,
**caractérisé en ce**
**que** le logiciel de test pour les éléments de circuit (3, 5) pour lesquels un signal X est apparu dans le logiciel de test (33, 35) lors du test avec tous les signaux de synchronisation, effectue d'abord des cycles de test pour lesquels seul l'un des signaux de synchronisation influençant le fonctionnement de la partie de circuit (3, 5) est désactivé et que le logiciel de test, si un signal X est également apparu dans ce test pour des parties de circuit (33, 35) déterminées, augmente le nombre des signaux de synchronisation désactivés jusqu'à ce qu'il n'apparaisse plus de signal X dans le modèle logiciel pour les parties de circuit (33, 35) et qu'une évaluation des résultats du test des parties de circuit correspondantes (3, 5) puisse intervenir.
